# FASCICULE DE BREVET EUROPEEN

(11) **EP 2 785 633 B1**
(45) Date de publication et mention de la délivrance du brevet: **30.12.2015**
(21) Numéro de dépôt: 12794949.3
(22) Date de dépôt: 29.11.2012
(51) Int. Cl.: B81B 3/00, F03G 7/06, H01L 41/113, H02N 10/00, H02N 2/00, H03H 9/15, F24J 3/00, H03H 9/24

(54) **DISPOSITIF ET PROCÉDÉ DE GENERATION D'UNE SECONDE VARIATION DE TEMPERATURE A PARTIR D'UNE PREMIERE VARIATON DE TEMPERATURE**
APPARAT UND VERFAHREN ZUR ERZEUGUNG EINER ZWEITEN TEMPERATURVARIATION AUFGRUND EINER ERSTEN TEMPERATURVARIATION
DEVICE AND METHOD OF GENERATING A SECOND VARIATION OF TMPERATURE CAUSED BY A FIRST VARIATION OF TEMPERATURE

(30) Priorité: 02.12.2011 FR 1161067
(43) Date de publication de la demande: 08.10.2014
(73) Titulaire: Commissariat à l'Énergie Atomique et aux Énergies Alternatives, 75015 Paris (FR)
(72) Inventeur: CASSET, Fabrice, F-38570 Tencin (FR)
(74) Mandataire: GIE Innovation Competence Group
(86) Numéro de dépôt international: PCT/EP2012/073968
(87) Numéro de publication internationale: WO 2013/079596

(56) Documents cités:
- US-A1- 2003 006 668
- US-A1- 2005 205 125
- US-A1- 2007 063 613
- US-A1- 2009 315 335
- US-A1- 2009 322 184
- US-A1- 2010 164 331
- US-A1- 2011 193 449
- US-A1- 2011 215 590
- US-B1- 6 367 281

## Description

L'invention concerne un dispositif et un procédé de génération d'une seconde variation ΔT₂ de température à partir d'une première variation ΔT₁ de température.

De tels dispositifs ont de très nombreuses applications. Par exemple, ces dispositifs s'avèrent utiles :
- pour accroître le rendement des dispositifs qui génèrent de l'électricité à partir d'une variation de température,
- pour annuler ou limiter les effets néfastes de la variation ΔT₁ de température en générant une variation ΔT₂ de température de sens opposé, ou
- pour amplifier la variation ΔT₁ de température.

De l'état de la technique est connu de : US2005/205125A1, US2011/193449A1, US2010/164331A1, US6367281B1, US2009/322184A1, US2007/063613A1, US2011/215590A1, US2003/006668A1, US2009/315335A1.

L'invention vise à proposer un dispositif simple de génération de la variation ΔT₂ de température à partir de la variation ΔT₁ de température. Elle a donc pour objet un tel dispositif conforme à la revendication 1.

L'utilisation d'un élément suspendu capable de faire varier d'au moins Δσ MPa la contrainte appliquée à la couche en matériau élastocalorique en réponse à la variation ΔT₁ de température, permet simplement de générer la variation ΔT₂ à partir de la variation ΔT₁ de température.

Dans la suite de cette description le terme « contrainte » désigne une contrainte mécanique. La contrainte mécanique est également connue sous le terme anglais de « stress ».

Les modes de réalisation de ce dispositif peuvent comporter une ou plusieurs des caractéristiques des revendications dépendantes.

Ces modes de réalisation du dispositif présentent en outre les avantages suivants :
- associer l'élément suspendu à un transducteur apte à convertir les déformations de l'élément suspendu en énergie électrique, permet d'obtenir un dispositif efficace pour générer de l'électricité à partir d'un gradient de température ;
- la réalisation de l'élément suspendu sous la forme d'un bilame permet simplement de transformer la variation ΔT₁ de température en une variation de la contrainte mécanique appliquée sur la couche en matériau élastocalorique supérieure à Δσ;
- utiliser la couche en matériau élastocalorique pour former l'une des couches du bilame simplifie la fabrication de ce dispositif ;
- associer la couche de matériau élastocalorique à un élément suspendu oscillant permet de limiter la variation de fréquence de cet élément oscillant en réponse à la variation ΔT₁ de température et donc de décroître la sensibilité de la fréquence d'oscillation vis-à-vis de telles variations de température ;
- choisir un matériau élastocalorique qui génère une variation ΔT₂ de température de sens opposé et d'amplitude sensiblement égale à la variation ΔT₁ dé température permet d'augmenter l'insensibilité de la fréquence d'oscillation de l'élément suspendu à la variation ΔT₁ de la température ambiante ou d'utilisation ;
- utiliser des matériaux ayant des coefficients de dilatation thermique différents pour réaliser l'élément suspendu et le substrat rigide sur lequel il est fixé, ou l'élément suspendu et le matériau élastocalorique, permet de générer facilement la contrainte dans la couche de matériau élastocalorique propre à générer la variation ΔT₂ de température ;
- la présence de la couche en matériau élastocalorique interposée entre l'élément suspendu et le substrat permet simplement d'exercer de fortes contraintes sur cette couche en cas de variation de la température ambiante ΔT₁;
- choisir un matériau élastocalorique qui génère une variation ΔT₂ de température de même sens que la variation ΔT₁ permet d'amplifier la variation de température et donc de générer plus de chaleur.

L'invention a également pour objet un procédé de génération d'une seconde variation de température à partir d'une première variation de température d'utilisation conforme à la revendication 15.

Les modes de réalisation du procédé peuvent comporter la caractéristique de la revendication 16.

L'invention sera mieux comprise à la lecture de la description qui va suivre, donnée uniquement à titre d'exemple non limitatif et faite en se référant aux dessins sur lesquels :
- les figures 1 et 2 sont des illustrations schématiques d'un dispositif de génération d'électricité à partir d'une variation de température, respectivement, dans deux positions différentes ;
- la figure 3 est un procédé de génération d'électricité à l'aide du dispositif des figures 1 et 2 ;
- la figure 4 est un organigramme d'un procédé de fabrication du dispositif des figures 1 et 2 ;
- les figures 5 à 10 sont des illustrations schématiques et en coupe transversale de différentes étapes de fabrication du dispositif des figures 1 et 2 ;
- la figure 11 est une illustration schématique d'un dispositif de compensation d'une variation de température ; et
- la figure 12 est une illustration schématique d'un dispositif d'amplification d'une variation de température.

Dans ces figures, les mêmes références sont utilisées pour désigner les mêmes éléments.

Dans la suite de cette description, les caractéristiques et fonctions bien connues de l'homme du métier ne sont pas décrites en détail.

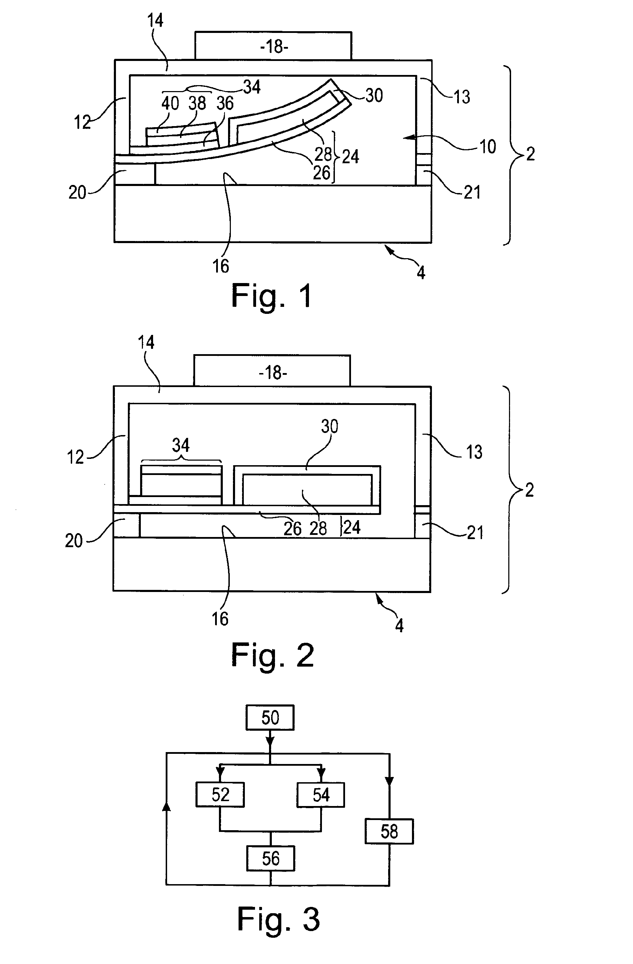

La figure 1 représente un dispositif 2 de génération d'électricité à partir d'un gradient de températures. Pour cela, ce dispositif génère notamment une seconde variation ΔT₂ de température à partir d'une première variation ΔT₁ de température. Ici, le dispositif 2 est un MEMS (Micro Electro-Mechanical System). Ce dispositif 2 est donc fabriqué en utilisant les mêmes procédés de fabrication que ceux utilisés pour fabriquer des composants en microélectronique. Typiquement, il est fabriqué par dépôt et gravure de couches successives les unes au-dessus des autres. Ici, ces couches sont déposées sur un substrat 4 qui s'étend essentiellement horizontalement. Le substrat 4 est par exemple un substrat en silicium de plusieurs dizaines de micromètres d'épaisseur. La plus grande largeur horizontale du dispositif 2 est donc ici typiquement inférieure à 1 cm ou 5 mm. Sa hauteur, dans la direction verticale est typique inférieure à 5 mm ou 1 mm.

Le dispositif 2 comporte une cavité 10 délimitée par des parois verticales 12 et 13, une paroi horizontale supérieure 14 et une paroi horizontale inférieure 16. Ici, la paroi 16 est constituée par le substrat 4.

Les parois 14 et 16 sont également appelées par la suite, respectivement, parois chaude et froide. En effet, ces parois sont destinées à être chauffées à des températures, respectivement, T_{c} et T_{f}, où la température T_{c} est strictement supérieure à la température T_{f} de manière à créer un gradient vertical de température. Typiquement, lors du fonctionnement du dispositif 2, l'écart entre les températures T_{c} et T_{f} est supérieur à 10°C et, de préférence, supérieur à 30°C ou 50°C. A cet effet, la paroi 14 est directement en contact avec une source 18 de chaleur.

Par exemple, la source 18 est un circuit intégré capable d'exécuter des opérations arithmétiques tel qu'un microprocesseur. La source 18 peut aussi être formée par des canalisations dans lesquelles circule un fluide caloporteur plus chaud que la température ambiante. Dans le cas de canalisations, de préférence, celles-ci sont logées à l'intérieur même de la paroi 14.

Ici, l'essentiel des parois 12 et 13 et de la paroi 14 sont formées par les parois d'un capot rapporté sur un logement creux défini dans le substrat 4 afin de former la cavité 10. Le logement creux est délimité sur ses côtés verticaux par des cales 20, 21, par exemple en oxyde, et par la paroi 16.

Un élément 24 suspendu au-dessus du substrat 4 est logé à l'intérieur de la cavité 10. Ici, cet élément 24 est une poutre qui s'étend entre une extrémité ou bord proximal et une extrémité ou bord distal. L'extrémité proximale est ancrée sans aucun degré de liberté dans la paroi 12. L'extrémité distale est libre de se déplacer verticalement à l'intérieur de la cavité 10. La longueur de cette poutre est typiquement comprise entre 50 µm et 1 mm. Sa largeur est comprise entre 1 µm et 100 µm.

L'élément 24 est apte à se déformer entre une position haute, représentée sur la figure 1, et une position basse, représentée sur la figure 2 en réponse à la variation ΔT₁ d'une température d'utilisation du dispositif 2. Dans la position haute, l'élément 24 est plus proche de la paroi 14 que dans sa position basse. A l'inverse, dans la position basse, l'élément 24 est plus proche de la paroi 16 que dans sa position haute.

Pour se déplacer entre les positions haute et basse, l'élément 24 est formé :
- d'une couche inférieure 26 réalisée dans un matériau ayant un coefficient 5, de dilatation thermique, et
- d'une couche supérieure 28 réalisée dans un matériau ayant un coefficient δ₂ de dilatation thermique.

Les couches 26 et 28 s'étendent essentiellement de l'extrémité proximale vers l'extrémité distale. Elles sont fixées l'une sur l'autre sans aucun degré de liberté de manière à former un bilame. Ici, la couche 28 est précontrainte de manière à ce que l'élément 24 soit dans sa position haute lorsque la source 18 ne chauffe pas.

Dans ce mode de réalisation, le coefficient δ₂ est supérieur au coefficient δ₁ de manière à ce que sous l'effet d'une augmentation de la température, l'élément 24 se déforme de sa position haute vers sa position basse.

Une couche 30 en matériau élastocalorique est disposée directement sur l'élément 24. Un matériau élastocalorique est un matériau qui transforme une variation de contrainte mécanique en une variation de sa température interne. Ici, un matériau est considéré comme « élastocalorique » lorsqu'il a la capacité de faire varier sa température interne d'au moins 1°C et, de préférence, d'au moins 5 ou 10°C en réponse à une variation donnée Δσ de la contrainte appliquée sur ce matériau. Pour que la propriété du matériau élastocalorique soit non négligeable, il faut généralement que la variation donnée Δσ soit inférieure à 2GPa ou 5GPa ou 10GPa. Par ailleurs, typiquement, la variation donnée Δσ est souvent supérieure à 1 ou 10 MPa, voire, 1 GPa. Il existe de nombreux matériaux élastocaloriques. Par exemple, les matériaux suivants sont de matériaux élastocaloriques : les alliages de nickel et de titane (NiTi), les alliages FeRh, les polymères ferroélectriques, le Cu_{68.13}Zn_{15.74}Al_{16.13} et le PZT (Titano-zirconate de plomb). Les propriétés élastocaloriques de ces matériaux proviennent souvent du fait qu'ils peuvent présenter deux phases cristallographiques appelées respectivement phase martensitique et phase austénitique par analogie aux aciers et la capacité de passer de l'une de ces phases à l'autre de façon réversible lorsqu'ils subissent une variation de contrainte. Le passage de l'une de ces phases à l'autre se traduit par un changement de la température interne du matériau élastocalorique.

Par exemple, l'étude des propriétés élastocaloriques du Cu_{68.13}Zn_{15.74}Al_{16.13} peut être consultée dans l'article suivant :
E. Bonnot, R. Romero, L. Manosa, E. Vives et A. Planes, «Elastocaloric effect associated with matensitic tansition in shape-memory alloys», PRL 100,125901, du 28 mars 2008.

En particulier, le graphe de la figure 1 de cet article indique qu'une variation de 35MPa de la contrainte mécanique appliquée sur le Cu_{68.13}Zn_{15.74}Al_{16.13} permet d'obtenir une variation de sa température de plus de 15°C. Des études similaires appliquées aux autres matériaux élastocaloriques cités ici permettent d'obtenir pour chacun d'entre eux la valeur de la variation donnée Δσ de contrainte qui permet d'obtenir une variation souhaitée ΔT₂ de la température interne de ce matériau. Ces études permettent aussi de déterminer si la température interne augmente quand la contrainte mécanique augmente ou l'inverse. En effet, il existe aussi des matériaux élastocaloriques dont la température diminue lorsque la contrainte mécanique appliquée augmente.

La couche 30 est fixée sans aucun degré de liberté sur l'élément 24 pour :
- subir la variation de contrainte causée par la déformation de cet élément entre les positions haute et basse, et
- échanger de la chaleur avec cet élément 24 par conduction thermique.

Par exemple, la couche 30 s'étend essentiellement le long de l'une des couches 26 ou 28 de l'élément 24. Ici, elle s'étend essentiellement directement sur la couche 28.

Dans ce mode de réalisation, le matériau élastocalorique de la couche 30 est choisi pour provoquer une baisse de sa température lorsque l'élément 24 se déforme de sa position haute vers sa position basse. Lors de cette déformation, la contrainte mécanique subie par la couche 30 diminue. Typiquement, la contrainte varie d'au moins 10 MPa et généralement de plus de 100 MPa ou 1 GPa. Le matériau élastocalorique choisi transforme cette variation de contrainte en une baisse de sa température interne.

Par exemple le matériau utilisé pour réaliser la couche 30 est le Cu_{68.13}Zn_{15.74}Al_{16.13}. Dans la suite de cette description, on suppose que la variation souhaitée ΔT₂ est d'environ 10°. Notons que pour ce matériau, cette variation souhaitée ΔT₂ correspond à une variation donnée Δσ de contrainte d'environ 27 MPa d'après les études réalisées sur ce matériau.

Ici, l'élément 24 est agencé pour générer cette variation donnée Δσ (27MPa) de contrainte dans la couche 30 en réponse à la variation ΔT₁ de la température d'utilisation. Dans ce mode de réalisation, la variation ΔT₁ est une variation de la température d'au moins une des parois 14 et 16. A titre d'exemple, c'est la température de la paroi 14 qui varie. Cette variation est causée par la source 18 de chaleur. L'amplitude des variations est supérieure à 10°C et, de préférence, à 50°C. Cela correspond par exemple au passage d'un état inactif de la source 18 à un état actif. Dans la suite de cette description, à titre d'illustration, on suppose que la variation ΔT₁ est de 50°C.

En réponse à cette variation ΔT₁, l'élément 24 se déplace entre ses positions haute et basse. Lors de ses déplacements, sa température augmente lorsqu'il se rapproche de la paroi 14 et, au contraire, diminue lorsqu'il se rapproche de la paroi 16. L'amplitude de la variation de température subie par l'élément 24 peut être estimée à partir de la connaissance des caractéristiques thermiques de la source 18 et du dispositif 2. Par exemple, ici, il est considéré que la température de l'élément 24 varie de plus de 10°C et, par exemple, de plus de 45°C entre sa position haute et sa position basse.

Typiquement, les dimensions de l'élément 24 et les matériaux des couches 26 et 28 permettant d'obtenir la variation donnée Δσ de la contrainte appliquée sur la couche 30 en réponse à la variation ΔT₁ de la température sont déterminés de façon expérimentale. Par exemple, pour cela, des simulations numériques des déformations de l'élément 24 pour différentes dimensions et différents matériaux sont réalisées à l'aide de logiciels de simulation tels que des logiciels de simulation par éléments finis. Par exemple, le tableau suivant donne quelques résultats pour différents agencements de l'élément 24 obtenus par simulation numérique en prenant ΔT₁ égal à 50°C.

| N° de l'agencement | Agencement de l'élément 24 (L = Longueur, l=largeur, e= épaisseur ; ces dimensions sont exprimées en µm) | Contrainte Δσ générée en MPa |
|---|---|---|
| 1 | Couche 28 en Aluminium (L=80,1=8, e=0,1) | 40 |
| | Couche 26 en Silicium (L=200,1=10, e=1) | |
| 2 | Couche 28 en SiO₂ (L=80,1=8, e=0,1) | 20 |
| | Couche 26 en Silicium (L=200,1=10, e=1) | |
| 3 | Couche 28 en SiO₂ (L=100,1=8, e=0,1) | 27 |
| | Couche 26 en Silicium (L=200,1=10, e=1) | |
| 4 | Couche 28 en SiO₂ (L=110,1=8, e=0,1) | 18 |
| | Couche 26 en Silicium (L=200,1=10, e=1) | |

D'après ce tableau, les agencements n°1 et 3 de l'élément 24 permettent d'appliquer à la couche 30 la variation de contrainte nécessaire pour faire varier (ΔT₂) sa température d'au moins 10°C lorsque la variation ΔT₁ est de 50°C.

Ici, les couches 26 et 28 ne sont pas réalisées dans un matériau élastocalorique.

Enfin, le dispositif 2 comporte également un transducteur 34 capable de transformer les déformations de l'élément 24 en énergie électrique. Ici, le transducteur 34 est un composant piézoélectrique fixé sans aucun degré de liberté sur l'élément 24 pour transformer la variation de contrainte causée par ses déformations en énergie électrique. Par exemple, le transducteur 34 comprend :
- une électrode conductrice 36 directement déposée sur la couche 28,
- une couche 38 en matériau piézoélectrique déposée directement sur l'électrode 36, et
- une électrode conductrice 40 déposée directement sur la couche 38.

Pour simplifier l'illustration, les connexions électriques des électrodes 36 et 40 avec des plots extérieurs à la cavité 10 n'ont pas été représentées.

Le fonctionnement du dispositif 2 va maintenant être décrit plus en détail en référence au procédé de la figure 3.

En absence de gradient thermique entre les parois 14 et 16 et pour une température de l'air ambiant de 20°C, l'élément 24 est dans sa position haute.

Lors d'une étape 50, la source 18 est activée et se met à chauffer la paroi 14 tandis que la paroi 16 est en contact avec l'air ambiant. L'activation de la source 18 provoque la variation ΔT₁ de la température de la paroi 14. Cela provoque également l'apparition d'un gradient de température entre les parois 14 et 16. Typiquement, ce gradient de température est supérieur à 30° et, ici, à 50°C.

En réponse, lors d'une étape 52, l'élément 24 qui se trouve dans sa position haute s'échauffe de ΔT₁. Sous l'action de cette augmentation de sa température interne, il se déforme de sa position haute vers sa position basse du fait de la dilatation différentielle des ses matériaux constitutifs. Lors de son déplacement, vers la position basse, sa température diminue car il s'éloigne de la paroi chaude 14 et se rapproche de la paroi froide 16. Le déplacement de l'extrémité distale lors de cette étape peut être calculé dans le cas d'une poutre. Par exemple, pour un tel calcul, on pourra se référer au livre suivant :
Emmanuel Defay, "Integration of ferroelectric and piezoelectric thin films", Wiley, 2011

En parallèle, lors d'une étape 54, lors de la déformation de l'élément 24 de sa position haute vers sa position basse, la contrainte exercée sur la couche 30 diminue de Δσ. En réponse, la température du matériau élastocalorique de la couche 30 diminue également et produit donc une variation ΔT₂ de sa température interne. Cette variation Δ2 accélère et augmente le refroidissement de l'élément 24 par conduction thermique entre la couche 30 et les couches 26 et 28. Cette variation de température interne de l'élément élastocalorique ΔT₂ s'oppose donc à la variation ΔT₁ subie initialement par l'élément 24.

Lors d'une étape 56, sous l'action conjuguée du refroidissement causé par son éloignement de la paroi 14 et par la baisse ΔT₂ de la température de la couche 30, l'élément 24 se déforme à nouveau pour retourner vers sa position haute. Les étapes 52 à 56 sont réitérées en boucle de sorte que l'élément 24 oscille lorsqu'un gradient de température est appliqué entre les parois 14 et 16. Ces oscillations peuvent être soit entretenues soit amorties. Lorsque ces oscillations sont amorties, si le gradient de température est maintenu constant indéfiniment, l'élément 24 tend à s'immobiliser après un certain nombre d'oscillations sur une position d'équilibre à mi-chemin entre ses positions haute et basse.

En parallèle des étapes 52 à 56, lors d'une étape 58 le transducteur 34 transforme les déformations mécaniques de l'élément 24 en énergie électrique. L'énergie électrique ainsi produite peut alors être utilisée pour alimenter un appareil électrique.

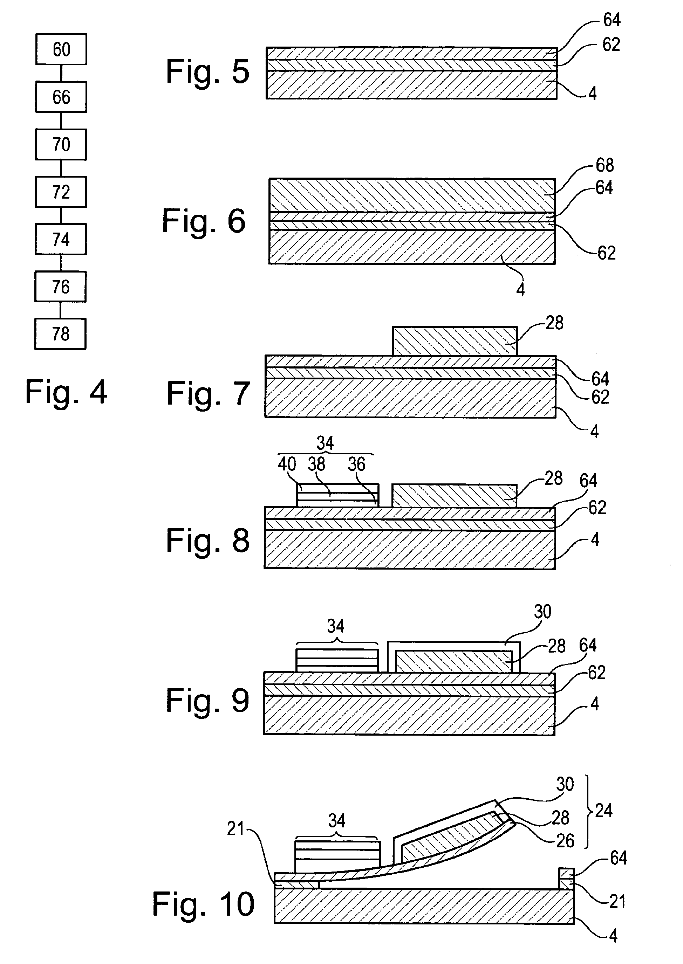

Un exemple de procédé de fabrication du dispositif 2 va maintenant être décrit en référence au procédé de la figure 4 et aux différentes illustrations des figures 5 à 10.

Le procédé débute par une étape 60 de fourniture d'un substrat SOI (Silicium On Insulator). Ce substrat est représenté sur la figure 15. Il se compose essentiellement, en allant du bas vers le haut, d'une couche de silicium correspondant au substrat 4 du dispositif 2, d'une couche d'oxyde 62 et d'une couche mince 64 en silicium. La couche 62 d'oxyde est par exemple réalisée en oxyde de silicium.

Ensuite, lors d'une étape 66, une couche d'oxyde 68 précontrainte est déposée sur la couche 64 de silicium. La contrainte exercée par la couche 68 est calibrée pour qu'à température ambiante, par exemple 20°C, l'élément 24 soit dans sa position haute. La contrainte dans la couche 68 peut être ajustée en jouant sur sa température ou sa vitesse de déposition par exemple. L'épaisseur de la couche 68 est typiquement comprise entre 100nm et 50µm et, de préférence, entre 200 nm et 10 ou 30 µm. La couche 68 est par exemple en oxyde de silicium ou en nitrure de silicium.

Lors d'une étape 70, la couche 68 est gravée pour former la couche 28 de l'élément 24 (voir figure 7).

Lors d'une étape 72, le transducteur 34 est réalisé sur la couche 64 à côté de la couche 28 (voir figure 8). Lors de cette étape 72, les électrodes 36 et 40 ainsi que la couche piézoélectrique 38 sont déposées et gravées de manière à obtenir le transducteur 34. Par exemple :
- la couche 36 est une couche de platine de 100 nm d'épaisseur,
- la couche 40 est une couche de ruthénium de 100 nm d'épaisseur, et
- la couche 38 est une couche en nitrure d'aluminium dont l'épaisseur est comprise entre 100 nm et 2,5 µm.

Lors d'une étape 74, une couche de matériau élastocalorique est déposée et gravée sur la couche 28 de manière à former la couche 30. L'épaisseur de la couche en matériau élastocalorique est par exemple comprise entre 100 nm et 10 µm (voir figure 9).

Lors d'une étape 76, les couches 64 et 62 sont gravées, par exemple par attaque chimique, pour former la couche 26 et libérer l'élément 24 (voir figure 10). Lorsque la couche 62 située sous la couche 64 est éliminée, l'élément 24 se déplace sous l'effet de la contrainte exercée par la couche 28 vers sa position haute.

Enfin, lors d'une étape 78, le capot formant les parois 12 à 14 est rapporté sur le substrat 4 pour délimiter la cavité 10. La source 18 de chaleur peut être fixée sur ce capot avant ou après que celui ne soit rapporté sur le substrat 4.

Ainsi, à l'issue de ce procédé, on obtient le dispositif 2 représenté sur la figure 1.

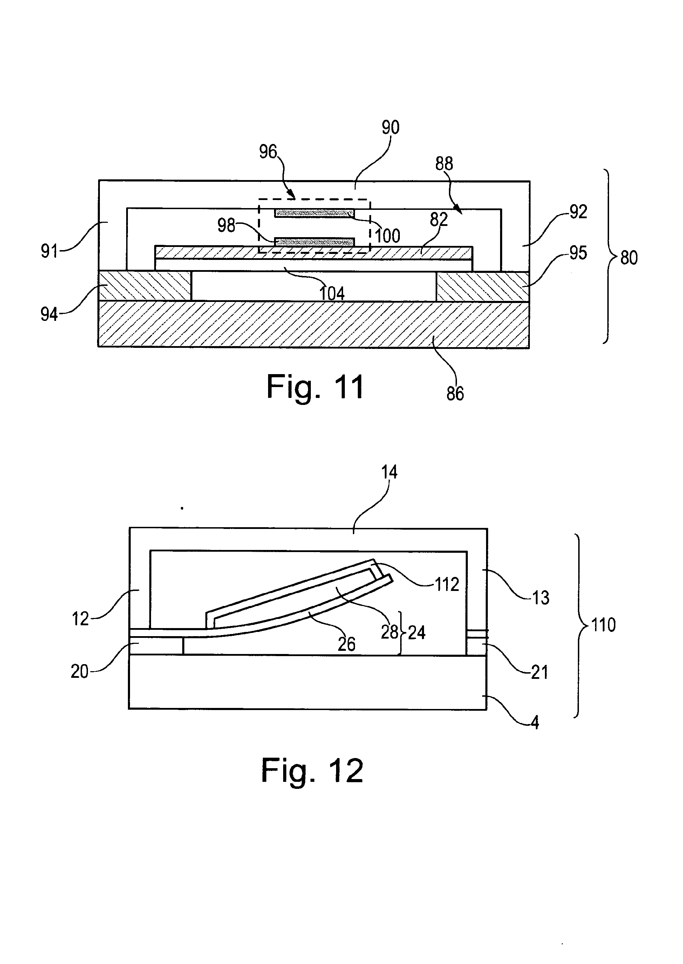

La figure 11 représente un dispositif 80 comportant un élément suspendu oscillant 82 compensé en température en mettant en oeuvre une transformation d'une variation ΔT₁ de la température d'utilisation en une variation souhaitée ΔT₂ de température de sens opposé. Ici la température d'utilisation est la température ambiante. Par exemple, le dispositif 80 est un oscillateur ou un accéléromètre. Comme précédemment, ce dispositif 80 est de préférence fabriqué en utilisant les mêmes procédés que ceux utilisés en microélectronique. Typiquement, il est réalisé par empilement et gravure d'une succession de couches sur un substrat horizontal 86. Ici, ce substrat 86 est réalisé dans un matériau présentant un coefficient λ₁ de dilatation thermique. Par exemple, le matériau du substrat 86 est du silicium.

Une cavité 88 est aménagée à l'intérieur du dispositif 80. Un élément suspendu 82 est logé à l'intérieur de cette cavité 88. La cavité 88 est délimitée par une paroi horizontale supérieure 90, une paroi horizontale inférieure et des parois verticales 91 et 92. La paroi horizontale inférieure est formée par le substrat 86. Les parois 90 à 92 sont celles d'un capot, par exemple, rapporté sur le substrat 86. Typiquement, le vide est réalisé à l'intérieur de la cavité 88 pour permettre l'oscillation de l'élément suspendu 82.

Dans ce mode de réalisation, l'élément 82 est une poutre qui s'étend horizontalement entre ses extrémités. Ces extrémités reposent chacune sur une cale, respectivement, 94 et 95. Par exemple, ces cales 94 et 95 sont réalisées en oxyde tel qu'un oxyde de silicium. Ces cales 94 et 95 sont fixées sans aucun degré de liberté sur le substrat 86. Ainsi, la partie centrale de l'élément 82 située entre ses extrémités est suspendue au-dessus du substrat 86 et peut se déplacer verticalement.

Ici, l'élément 82 est réalisé dans un matériau présentant un coefficient λ₂ de dilatation thermique.

Dans ces conditions, comme pour le dispositif 2, sous l'action d'une variation ΔT₁ de température, l'élément 82 se déforme entre une position contractée et une position dilatée. Par exemple, les matériaux de l'élément 82 et du substrat 84 sont choisis tel que le coefficient λ₂ soit inférieur au coefficient λ₁ de dilatation thermique. Dans ces conditions, si la température augmente, le substrat 86 exerce sur l'élément 82 une contrainte qui tend à l'étirer.

Le dispositif 80 comporte aussi un actionneur 96 apte à faire osciller l'élément 82 entre deux états nommés, respectivement, haut et bas. Dans l'état haut, la partie centrale de l'élément 84 est incurvée vers le haut et se rapproche donc de la paroi supérieure 90. Dans l'état bas, la partie centrale est incurvée vers le bas et se rapproche donc du substrat 86.

Sur la figure 11, l'élément 82 est représenté dans un état intermédiaire entre les états haut et bas dans lequel l'élément 82 s'étend horizontalement.

Par exemple, l'actionneur 96 est un actionneur électrostatique. A cet effet, il comporte une électrode 98 fixée sans aucun degré de liberté sur l'élément 82 et une autre électrode 100 fixée sans aucun degré de liberté en vis-à-vis de l'électrode 98 sur la paroi 90. Pour simplifier la figure 11, les connexions électriques entre ces électrodes 98 et 100 et l'extérieur de la cavité 88 n'ont pas été représentées.

Enfin, le dispositif 80 comporte une couche 104 en matériau élastocalorique déposée le long de l'élément 82 pour subir les contraintes mécaniques causées par la dilatation du substrat 86 en réponse à la variation ΔT₁ de température. Ici, cette couche 104 s'étend continûment et directement le long de l'élément 88 entre ses deux extrémités pour échanger de la chaleur par conduction thermique avec cet élément 82. La couche 104 est située au-dessous la couche 82. Elle est donc interposée entre les extrémités de l'élément 82 et les cales 94 et 95.

Le matériau élastocalorique de la couche 104 est tel que, lorsqu'il est étiré dans sa direction horizontale, sa température interne décroît. De préférence, le matériau élastocalorique choisi permet d'obtenir une variation ΔT₂ de température égale à plus ou moins 25 % près et, de préférence, à plus ou moins 10 ou 5 % près à l'inverse de la variation ΔT₁ qui cause la déformation de l'élément 82 entre ses positions contractée et dilatée. Comme précédemment, le matériau élastocalorique et l'agencement de l'élément 82 sont déterminés expérimentalement à partir :
- d'abaques donnant la variation de la température interne de la couche 104 en fonction de la variation de la contrainte mécanique appliquée, et
- de simulations numériques donnant la variation de la contrainte appliquée sur la couche 104 en fonction de l'agencement de l'élément 82.

Par exemple, la variation donnée Δσ de la contrainte mécanique appliquée sur la couche 104 est calculée par simulation numérique pour une variation donnée ΔT₁ de la température ambiante. Typiquement, on prendra une variation donnée ΔT₁ supérieure à 10°C. Ensuite, on recherche s'il existe un matériau élastocalorique dont la température varie de ΔT₂ en réponse à la variation donnée Δσ de la contrainte appliquée, où ΔT₂ est égal à -ΔT₁ à plus ou moins 25% ou 10% et, de préférence, 5% près. Dans l'affirmative, ce matériau est sélectionné pour réaliser la couche 104. Si aucun matériau élastocalorique présentant la variation ΔT₂ souhaitée ne peut être trouvé, alors la géométrie ou le matériau de l'élément 82 est modifié pour modifier la valeur calculée de la contrainte donnée Δσ. Ensuite, les étapes précédentes sont réitérées jusqu'à ce qu'un agencement de l'élément 82 corresponde à un matériau élastocalorique existant pour réaliser la couche 104.

Le fonctionnement du dispositif 80 est le suivant. L'actionneur 96 est alimenté avec une tension alternative, ce qui fait osciller l'élément 82 entre ses états haut et bas à une fréquence donnée. Chaque déformation de l'élément 82 vers l'état haut ou bas entraîne une déformation de la couche 104 et donc l'apparition d'une contrainte mécanique dans cette couche. Chaque variation de contrainte subie par la couche 104 est transformée en une variation de sa température interne. Toutefois, ces modifications de la température interne de la couche 104 ne modifient pas ou uniquement de façon négligeable la température de l'élément 82. En effet, les contraintes subies par la couche 104 causées par les oscillations de l'élément 82 sont dans un sens puis, en alternance, dans le sens opposé. Ainsi, la température de la couche 104 oscille entre deux températures avec la même fréquence d'oscillation que celle de l'élément 82. A cause de l'inertie thermique du matériau formant l'élément 82 les variations de température dans un sens et dans le sens opposé causées par la conduction thermique avec la couche 104 s'annulent à l'intérieur de l'élément 82. Ainsi, les oscillations de l'élément 82 ne provoquent pas une oscillation de sa température ou simplement une oscillation de température de très faible amplitude, c'est-à-dire par exemple inférieur à 5 ou 1°C. Dès lors, la température de l'élément 82 est sensiblement égale à la température ambiante du milieu dans lequel il est plongé.

Si la température ambiante augmente, la température des différents éléments du dispositif 80 augmente également. Par exemple, ici, on suppose que la température augmente de 10°C. Cette variation de la température, notée ΔT₁, provoque, en réponse, une dilatation du substrat 86. L'élément 82 se dilate moins que le substrat 86. Dès lors, la contrainte mécanique donnée Δσ qui étire l'élément 82 apparaît. Cette contrainte est susceptible de modifier la fréquence d'oscillation de l'élément 82 si rien n'est fait.

Toutefois, ici, cette contrainte Δσ s'exerce également sur la couche 104. En réponse, la température interne de la couche 104 diminue de ΔT₂. Cette variation ΔT₂ de la température de la couche 104 est transmise par conduction thermique à l'élément 82, ce qui vient diminuer et, de préférence annuler la variation ΔT₁ de température. Ainsi, la fréquence d'oscillation de l'élément 82 est rendue plus insensible aux variations de température.

La figure 12 représente un dispositif 110 d'amplification d'une variation ΔT₁ de température. Dans ce dispositif 110, une variation souhaitée ΔT₂ de température est générée pour venir s'ajouter à la variation ΔT₁ de température. Le dispositif 110 est par exemple identique au dispositif 2 sauf que le transducteur 34 est omis et que la couche 30 est remplacée par une couche 112. La couche 112 est identique à la couche 30 sauf qu'elle est réalisée dans un matériau élastocalorique dont la température croît quand l'élément 24 se déplace de sa position haute vers sa position basse.

Le dispositif 110 n'utilise pas la source 18 de chaleur.

Le fonctionnement du dispositif 110 est le suivant. Lorsque la température ambiante du milieu dans lequel est plongé le dispositif 110 augmente, cela produit la variation ΔT₁ de la température de l'élément 24. En réponse, l'élément 24 se déforme de sa position haute vers sa position basse. La couche 112 transforme alors la variation de contrainte correspondante en la variation souhaitée ΔT₂ de sa température interne. Les variations ΔT₁ et ΔT₂ de température se cumulent, par exemple à l'intérieur de l'élément 24 ou de la couche 112 de sorte que la température atteinte par l'élément 24 et la couche 112 est supérieure à la température ambiante. Ce dispositif permet donc d'amplifier la variation ΔT₁ de température.

De nombreux autres modes de réalisation sont possibles. Par exemple, le matériau piézoélectrique du transducteur 34 peut être du PZT, de l'AIN ou autres.

Le transducteur 34 peut fonctionner également à l'aide d'un principe physique différent. Par exemple, il peut être remplacé par un transducteur capacitif ou magnétique capable de convertir l'énergie mécanique des déformations de l'élément suspendu en énergie électrique. A titre d'illustration, un transducteur capacitif est réalisé en fixant une électrode sur l'élément 24 et une autre électrode, en vis-à-vis, sur le substrat 4. La variation de capacité entre ces deux électrodes est alors convertie en énergie électrique.

L'élément 24 peut être fixé ailleurs. Par exemple, il est fixé directement sur la paroi 14 ou sur la paroi froide 16.

Le dispositif 2 peut aussi être facilement adapté pour fonctionner dans le cas où un gradient de température négatif entre la température ambiante et un point froid est créé. Par exemple, la source 18 est remplacée par un point froid dont la température devient inférieure à la température ambiante du milieu dans lequel est plongé le dispositif 2 lorsque cette source est activée. Dans ce cas, l'élément suspendu est adapté pour se déformer du point haut vers le point bas en réponse à une baisse de température. De plus, le matériau élastocalorique de la couche 30 est remplacé par un matériau élastocalorique dont la température augmente quand l'élément suspendu se déplace de sa position haute vers sa position basse.

En variante, en absence de gradient de température, la position de l'élément suspendu 24 est plus proche de la paroi froide que de la paroi chaude. Dans ce cas, pour fonctionner, l'élément suspendu est adapté pour se déplacer de sa position basse vers sa position haute en réponse à une augmentation ΔT₁ de la température. Dans ce mode de réalisation, la température du matériau élastocalorique augmente quand l'élément suspendu se déforme de sa position basse vers sa position haute.

En variante, la couche 26 est réalisée en matériau élastocalorique et la couche 30 est omise. Dans ce cas, le bilame est formé par la juxtaposition de la couche 28 et de la couche en matériau élastocalorique.

D'autres moyens techniques sont possibles pour que l'élément suspendu se déforme de sa position haute vers sa position basse en réponse à une variation de température. Par exemple, l'élément suspendu est une poutre ancrée à ses deux extrémités sans aucun degré de liberté sur un substrat 4 ayant un coefficient de dilatation thermique différent. Dans ce cas, il n'est pas nécessaire que l'élément suspendu soit un bilame.

Pour le dispositif 80, d'autres actionneurs 96 sont possibles pour faire osciller l'élément 82. Par exemple, l'actionneur 96 est remplacé par un actionneur piézoélectrique ou magnétique.

Une couche supplémentaire de matériau élastocalorique, par exemple identique à la couche 104, peut être déposée sur l'élément 82 du côté opposé à la couche 104. Lorsque cette couche supplémentaire est utilisée, la couche 104 interposée entre l'élément 82 et le substrat 86 peut être omise.

Le coefficient de dilatation λ₁ n'est pas nécessairement supérieur au coefficient de dilatation λ₂. En variante, l'inverse est également possible. Dans ce cas, lorsque la température augmente, la couche en matériau élastocalorique est comprimée. Il faut donc utiliser un matériau élastocalorique dont la température décroît quand le matériau est comprimé. Une autre solution consiste à conserver le même matériau élastocalorique mais à utiliser un montage mécanique de l'élément suspendu qui assure que celui-ci subisse une traction quand la température augmente. Enfin, dans un autre mode de réalisation, il n'est pas nécessaire que les coefficients de dilatation des matériaux utilisés pour réaliser l'élément 82 et le substrat 86 soient différents. Ils peuvent aussi être égaux. Dans ce cas, la dilatation différentielle de ces éléments est provoquée par le fait que ces éléments ne sont pas chauffés à la même température.

Quel que soit le mode de réalisation précédemment décrit, la couche en matériau élastocalorique peut se trouver aussi bien sur le dessus que sur le dessous et des deux côtés ou d'un seul côté à la fois.

La couche en matériau élastocalorique peut bien entendu être mono ou multicouches.

Dans d'autres modes de réalisation, l'élément suspendu peut se déformer non pas dans une direction perpendiculaire au plan du substrat mais dans une direction parallèle au plan du substrat. Dans ce cas, la couche en matériau élastocalorique se trouve au moins sur l'une des faces verticales de cet élément suspendu.

La couche en matériau élastocalorique peut recouvrir qu'une partie de l'élément suspendu. Par exemple, la couche en matériau élastocalorique sera disposée uniquement aux emplacements où les contraintes mécaniques subies sont maximales.

A l'inverse, l'élément suspendu peut être déposé uniquement dans certains emplacements non continus le long de la couche en matériau élastocalorique.

Les dispositifs précédemment décrits peuvent aussi être fabriqués à l'aide d'autres technologies et, en particulier, à l'aide des mêmes procédés de fabrication que ceux utilisés pour fabriquer des dispositifs macroscopiques. Ainsi, dans ce dernier cas, les dispositifs fabriqués sont ni des NEMS (Nanoelectromechanical systems) ni des MEMS mais des dispositifs à une échelle macroscopique, c'est-à-dire dont la dimension la plus large est supérieure à au moins 1 cm et, de préférence, à 5 cm ou 10 cm.

L'élément suspendu n'est pas nécessairement une poutre ancrée dans un substrat par une ou deux de ses extrémités. Par exemple, l'élément suspendu peut aussi être formé d'une membrane dont toute la périphérie est ancrée sur le substrat de manière à laisser sa partie centrale libre de se déformer.

L'élément suspendu peut être réalisé dans un seul bloc de matière ou, au contraire, par un empilement de plusieurs couches de différents matériaux.

Les cavités des dispositifs décrits précédemment peuvent être réalisées différemment que par le report d'un capot. Par exemple, elles peuvent être directement creusées dans le substrat.

Les dispositifs précédemment décrits sont typiquement voués à être incorporés dans des composants plus grands tels qu'un capteur, un microsystème, un résonateur, un oscillateur ou un actionneur.

## Revendications

1. Dispositif de génération d'une seconde variation ΔT₂ de température à partir d'une première variation ΔT₁ de température d'utilisation, ce dispositif comportant :
- une couche (30 ; 104 ; 112) en matériau élastocalorique dont la température interne est apte à varier de ΔT₂ en réponse à une variation donnée Δσ d'une contrainte mécanique appliquée sur cette couche en matériau élastocalorique, la variation donnée Δσ étant induite par la première variation ΔT₁ de température
- un élément suspendu (24 ; 82) en contact mécanique avec la couche en matériau élastocalorique de manière à appliquer sur cette couche une contrainte mécanique qui varie en réponse à la variation ΔT₁ de température d'utilisation,
**caractérisé en ce que** l'élément suspendu (24 ; 82) est agencé de manière à faire varier de Δσ la contrainte mécanique appliquée sur la couche en matériau élastocalorique en réponse à la variation ΔT₁ de température pour générer ainsi la seconde variation ΔT₂ de température.

2. Dispositif selon la revendication 1, dans lequel la température du matériau élastocalorique est apte à varier d'au moins 1°C en réponse à la variation donnée Δσ de la contrainte mécanique et l'élément suspendu (24 ; 82) est conformé de manière à faire varier la contrainte mécanique appliquée sur la couche en matériau élastocalorique d'au moins Δσ MPa en réponse à la variation ΔT₁ de température d'utilisation.

3. Dispositif selon l'une quelconque des revendications précédentes, dans lequel l'amplitude de la variation ΔT₁ est supérieure à 10°C.

4. Dispositif selon l'une quelconque des revendications précédentes, dans lequel la variation donnée Δσ en réponse à la variation ΔT₁ est d'au moins 1 MPa.

5. Dispositif selon l'une quelconque des revendications précédentes pour générer de l'électricité, dans lequel :
- le dispositif comporte une cavité (10) délimitée par, d'un côté, une paroi (14) dite « chaude » destinée à dissiper de la chaleur à l'intérieur de la cavité et, du côté opposé, une paroi (16) dite « froide » destinée à avoir une température inférieure à la paroi chaude,
- l'élément suspendu (24) est disposé à l'intérieur de la cavité entre les parois chaude et froide, l'élément suspendu étant apte à se déformer entre une position plus proche de la paroi chaude vers une position plus proche de la paroi froide ou inversement sous l'action de la variation ΔT₁ de la température d'une de ces parois,
- le matériau élastocalorique est apte à transformer la variation de contrainte mécanique qu'il subit lorsque l'élément suspendu se déforme en une baisse ΔT₂ de sa température interne si l'élément suspendu se déforme de sa position la plus proche de la paroi chaude vers sa position la plus proche de la paroi froide sous l'action de la variation ΔT₁ ou en une hausse ΔT₂ de sa température interne si l'élément suspendu se déforme de sa position la plus proche de la paroi froide vers sa position la plus proche de la paroi chaude sous l'action de la variation ΔT₁, et
- ce dispositif comporte un transducteur (34) apte à convertir la déformation de l'élément suspendu en énergie électrique.

6. Dispositif selon la revendication 5, dans lequel l'élément suspendu (24) comprend une première et une seconde couches (26, 28) de matériau directement fixées l'une sur l'autre sans aucun degré de liberté, chacune de ces couches étant réalisée dans un matériau ayant un coefficient de dilatation thermique différent de l'autre couche de manière à former un bilame apte à se déformer sous l'action de la variation ΔT₁ de température.

7. Dispositif selon la revendication 6, dans lequel l'une de la première et de la seconde couche (26, 28) est réalisée dans le matériau élastocalorique pour former la couche en matériau élastocalorique et l'autre de la première et de la seconde couche (26, 28) est réalisée dans un matériau incapable de générer une variation de température supérieure à 0,5°C en réponse à la variation Δσ de contrainte mécanique appliquée sur cette couche.

8. Dispositif selon l'une quelconque des revendications 1 à 4, dans lequel le dispositif comporte un actionneur (96) apte à faire osciller l'élément suspendu (82) entre deux états à une fréquence prédéterminée pour une température prescrite d'utilisation, et le matériau élastocalorique est apte à transformer la variation de contrainte mécanique qu'il subit lorsque la température d'utilisation de l'élément suspendu varie de ΔT₁ en une variation ΔT₂ de température de sens opposé à la variation ΔT₁ de température.

9. Dispositif selon la revendication 8, dans lequel le matériau élastocalorique est apte à transformer la variation de contrainte mécanique qu'il subit, lorsque la température d'utilisation de l'élément suspendu (82) varie de ΔT₁, en une variation ΔT₂ de sa température interne dont l'amplitude est égale à l'amplitude de la variation ΔT₁ à plus ou moins 25 % près.

10. Dispositif selon la revendication 8 ou 9, dans lequel :
- l'élément suspendu (82) est essentiellement réalisé dans un premier matériau présentant un premier coefficient de dilatation thermique et s'étendant entre deux extrémités,
- le dispositif comporte un substrat rigide (86) sur lequel les extrémités de l'élément suspendu sont fixées sans aucun degré de liberté, ce substrat étant réalisé dans un second matériau présentant un second coefficient de dilatation thermique différent du coefficient du premier matériau de sorte que la variation ΔT₁ de température d'utilisation fait varier la contrainte mécanique qui s'exerce sur l'élément suspendu.

11. Dispositif selon l'une quelconque des revendications 8 à 10, dans lequel la couche (104) en matériau élastocalorique est interposée entre au moins l'une desdites extrémités de l'élément suspendu (82) et le substrat (86).

12. Dispositif selon l'une quelconque des revendications 1 à 4, dans lequel la couche (112) en matériau élastocalorique est apte à transformer la variation de contrainte qu'elle subit, lorsque la température de l'élément suspendu varie de ΔT₁, en une variation ΔT₂ de sa température interne de même sens que la première variation ΔT₁ de température.

13. Dispositif selon l'une quelconque des revendications précédentes, dans lequel le matériau élastocalorique est choisi dans le groupe composé du Cu_{68.13}Zn_{15.74}Al_{16.13}, les alliages de nickel et de titane, les alliages FeRh, le PZT, les polymères ferroélectriques.

14. Dispositif selon l'une quelconque des revendications précédentes, dans lequel l'élément suspendu (24 ; 82) s'étend essentiellement dans une direction principale et la couche (30 ; 104 ; 112) en matériau élastocalorique recouvre au moins 50 % de l'élément suspendu dans cette direction principale.

15. Procédé de génération d'une seconde variation ΔT₂ de température à partir d'une première variation ΔT₁ de température d'utilisation, ce procédé comportant :
- la variation ΔT₁ (52) de la température d'utilisation d'un dispositif comportant un élément suspendu, cet élément suspendu étant conformé de manière à faire varier d'au moins Δσ MPa la contrainte mécanique appliquée sur une couche en matériau élastocalorique en contact mécanique avec cet élément suspendu en réponse à la variation ΔT₁ de la température d'utilisation, et
- en réponse, la variation d'au moins Δσ MPa de la contrainte mécanique appliquée par l'élément suspendu sur la couche en matériau élastocalorique en contact mécanique avec cet élément suspendu, et
- la transformation (54) par la couche en matériau élastocalorique de cette variation de contrainte mécanique en une variation ΔT₂ de sa température interne qui s'oppose ou, au contraire, augmente la variation ΔT₁ de la température d'utilisation.

16. Procédé selon la revendication 15, dans lequel l'amplitude de la variation ΔT₁ est supérieure à 10°C et/ou l'amplitude de la variation ΔT₂ est supérieure à 10°C.

## Patentansprüche

1. Apparat zur Erzeugung einer zweiten Temperaturvariation ΔT₂ auf Grund einer ersten Verwendungstemperaturvariation ΔT₁, wobei dieser Apparat umfasst:
- eine Schicht (30; 104; 112) aus einem elastokalorischen Material, deren innere Temperatur geeignet ist, um ΔT₂ als Antwort auf eine gegebene Variation Δσ einer an diese Schicht aus elastokalorischem Material angelegten Spannung zu variieren, wobei die gegebene Variation Δσ durch die erste Temperaturvariation ΔT₁ induziert wird,
- ein hängendes Element (24; 82) in mechanischem Kontakt mit der Schicht aus elektrokalorischem Material, um an diese Schicht eine mechanische Spannung anzulegen, die als Antwort auf die Verwendungstemperaturvariation ΔT₁ variiert, **dadurch gekennzeichnet, dass** das hängende Element (24; 82) derart angeordnet ist, dass es die an die Schicht aus elastokalorischem Material als Antwort auf die Temperaturvariation ΔT₁ angelegte mechanische Spannung um Δσ variiert, um auf diese Weise die zweite Temperaturvariation ΔT₂ zu erzeugen.

2. Apparat nach Anspruch 1, bei dem die Temperatur des elastokalorischen Materials geeignet ist, um mindestens 1°C als Antwort auf die gegebene Variation Δσ der mechanischen Spannung zu variieren, und das hängende Element (24; 82) derart ausgebildet ist, dass es die an die Schicht aus elastokalorischem Material angelegte mechanische Spannung um mindestens Δσ MPa als Antwort auf die Verwendungstemperaturvariation ΔT₁ variiert.

3. Apparat nach einem der vorhergehenden Ansprüche, bei dem die Amplitude der Variation ΔT₁ größer als 10°C ist.

4. Apparat nach einem der vorhergehenden Ansprüche, bei dem die gegebene Variation Δσ als Antwort auf die Variation ΔT₁ mindestens 1 MPa ist.

5. Apparat nach einem der vorhergehenden Ansprüche, um Elektrizität zu erzeugen, bei dem:
- der Apparat einen Hohlraum (10) umfasst, der auf einer Seite durch eine so genannte "heiße" Wand (14) begrenzt ist, die dazu bestimmt ist, die Wärme im Inneren des Hohlraums zu verteilen, und auf der gegenüberliegenden Seite durch eine so genannte "kalte" Wand (16), die dazu bestimmt ist, eine niedrigere Temperatur als die heiße Wand zu haben,
- das hängende Element (24) im Inneren des Hohlraums zwischen den heißen und kalten Wänden angeordnet ist, wobei das hängende Element geeignet ist, sich zwischen einer Position näher zur heißen Wand und einer Position näher zur kalten Wand oder umgekehrt unter der Wirkung der Temperaturvariation ΔT₁ einer dieser Wände zu verformen,
- das elastokalorische Material geeignet ist, die Variation der mechanischen Spannung, der es ausgesetzt ist, wenn sich das hängende Element verformt, in eine Verringerung seiner inneren Temperatur ΔT₂ umzuformen, wenn sich das hängende Element von seiner nächsten Position zur heißen Wand in seine nächste Position zur kalten Wand unter der Wirkung der Variation ΔT₁ verformt, oder in eine Erhöhung seiner inneren Temperatur ΔT₂, wenn sich das hängende Element von seiner nächsten Position zur kalten Wand in seine nächste Position zur heißen Wand unter der Wirkung der Variation ΔT₁ verformt, und
- dieser Apparat einen Wandler (34) umfasst, der geeignet ist, die Verformung des hängenden Elements in elektrische Energie umzuwandeln.

6. Apparat nach Anspruch 5, bei dem das hängende Element (24) eine erste und eine zweite Materialschicht (26, 28) umfasst, die direkt aneinander ohne Freiheitsgrad befestigt sind, wobei jede der Schichten aus einem Material mit einem zur anderen Schicht unterschiedlichen Wärmedehnungskoeffizienten hergestellt ist, um ein Bimetall zu bilden, das geeignet ist, sich unter der Wirkung der Temperaturvariation ΔT₁ zu verformen.

7. Apparat nach Anspruch 6, bei dem eine der ersten und zweiten Schicht (26, 28) aus dem elastokalorischen Material hergestellt ist, um die Schicht aus elastokalorischem Material zu bilden, und die andere der ersten und zweiten Schicht (26, 28) aus einem Material hergestellt ist, das nicht geeignet ist, eine Temperaturvariation über 0,5°C als Antwort auf die Variation Δσ der an diese Schicht angelegten mechanischen Spannung zu erzeugen.

8. Apparat nach einem der Ansprüche 1 bis 4, wobei der Apparat einen Aktuator (96) umfasst, der geeignet ist, das hängende Element (82) zwischen zwei Zuständen bei einer vorbestimmten Frequenz für eine vorgeschriebene Verwendungstemperatur oszillieren zu lassen, und das elastokalorische Material geeignet ist, die Variation der mechanischen Spannung, der es ausgesetzt ist, wenn die Verwendungstemperatur des hängenden Elements um ΔT₁ variiert, in eine Temperaturvariation ΔT₂ von zur Temperaturvariation ΔT₁ entgegengesetzter Richtung umzuformen.

9. Apparat nach Anspruch 8, bei dem das elastokalorische Material geeignet ist, die Variation einer mechanischen Spannung, der es ausgesetzt ist, wenn die Verwendungstemperatur des hängenden Elements (82) um ΔT₁ variiert, in eine Variation ΔT₂ seiner inneren Temperatur umzuformen, deren Amplitude gleich der Amplitude der Variation ΔT₁ zu mehr oder weniger ungefähr 25% ist.

10. Apparat nach Anspruch 8 oder 9, bei dem:
- das hängende Element (82) im Wesentlichen aus einem ersten Material hergestellt ist, das einen ersten Wärmedehnungskoeffizienten aufweist und sich zwischen zwei Enden erstreckt,
- der Apparat ein starres Substrat (86) umfasst, auf dem die Enden des hängenden Elements ohne Freiheitsgrad befestigt sind, wobei dieses Substrat aus einem zweiten Material hergestellt ist, das einen zweiten Wärmedehnungskoeffizienten, anders als der Koeffizient des ersten Materials aufweist, so dass die Verwendungstemperaturvariation ΔT₁ die mechanische Spannung, die auf das hängende Element ausgeübt wird, variiert.

11. Apparat nach einem der Ansprüche 8 bis 10, bei dem die Schicht (104) aus elastokalorischem Material zwischen mindestens einem der Enden des hängenden Elements (82) und dem Substrat (86) angeordnet ist.

12. Apparat nach einem der Ansprüche 1 bis 4, bei dem die Schicht (112) aus elastokalorischem Material geeignet ist, die Spannungsvariation, der es ausgesetzt ist, wenn die Temperatur des hängenden Elements um ΔT₁ variiert, in eine Variation ΔT₂ seiner inneren Temperatur von derselben Richtung wie die erste Temperaturvariation ΔT₁ umzuformen.

13. Apparat nach einem der vorhergehenden Ansprüche, bei dem das elastokalorische Material aus der Gruppe ausgewählt ist, bestehend aus Cu_{68.13}Zn_{15.74}Al_{16.13}, den Legierungen aus Nickel und Titan, den FeRh-Legierungen, PZT, den ferroelektrischen Polymeren.

14. Apparat nach einem der vorhergehenden Ansprüche, bei dem sich das hängende Element (24; 82) im Wesentlichen in eine Hauptrichtung erstreckt und die Schicht (30; 104; 112) aus elastokalorischem Material mindestens 50% des hängenden Elements in diese Hauptrichtung bedeckt.

15. Verfahren zur Erzeugung einer zweiten Temperaturvariation ΔT₂ auf Grund einer ersten Verwendungstemperaturvariation ΔT₁, wobei dieses Verfahren umfasst:
- die Variation ΔT₁ (52) der Verwendungstemperatur eines Apparats, umfassend ein hängendes Element, wobei dieses hängende Element derart ausgebildet ist, dass es um mindestens Δσ MPa die mechanische Spannung, die an eine Schicht aus einem elastokalorischen Material in mechanischem Kontakt mit diesem hängenden Element als Antwort auf die Verwendungstemperaturvariation ΔT₁ angelegt wird, variiert, und
- als Antwort die Variation um mindestens Δσ MPa der mechanischen Spannung, die von dem hängenden Element an die Schicht aus elastokalorischem Material in mechanischem Kontakt mit diesem hängenden Element angelegt wird, und
- durch die Schicht aus elastokalorischem Material die Umwandlung (54) dieser Variation der mechanischen Spannung in eine Variation ΔT₂ seiner inneren Temperatur, die sich der Variation ΔT₁ der Verwendungstemperatur entgegenstellt oder diese hingegen vergrößert.

16. Verfahren nach Anspruch 15, bei dem die Amplitude der Variation ΔT₁ größer als 10°C und/oder die Amplitude der Variation ΔT₂ größer als 10°C ist.

## Claims

1. Device for generating a second temperature variation ΔT₂ from a first use temperature variation ΔT₁, this device including :
- an elastocaloric material layer (30 ; 104 ; 112) the internal temperature of which is able to vary by ΔT₂ in response to a given mechanical stress variation Δσ applied to this elastocaloric material layer, the given variation Δσ being induced by the first temperature variation ΔT₁.
- a suspended element (24 ; 82) in mechanical contact with the elastocaloric material layer so as to apply to this layer a mechanical stress that varies in response to the use temperature variation ΔT₁,
**characterized in that** the suspended element (24 ; 82) is arranged so as to make the mechanical stress applied to the elastocaloric material layer vary by Δσ in response to the temperature variation ΔT₁, to generate thereby the second temperature variation ΔT₂.

2. Device according to Claim 1, wherein the temperature of the elastocaloric material is capable of varying by at least 1°C in response to the given mechanical stress variation Δσ and the suspended element (24 ; 82) is formed so as to make the mechanical stress applied to the elastocaloric material layer vary by at least Δσ MPa in response to the use temperature variation ΔT₁.

3. Device according to either one of the preceding claims, wherein the amplitude of the variation ΔT₁, is greater than 10°C.

4. Device according to any one of the preceding claims, wherein the given variation Δσ in response to the variation ΔT₁ is of at least 1 MPa.

5. Device according to any one of the preceding claims for generating electricity, wherein :
- the device includes a recess (10) delimited by, on one side, a wall (14) known as "hot" intended to dissipate heat inside the recess and, on the opposite side, a wall (16) known as "cold" intended to have a lower temperature than the hot wall,
- the suspended element (24) is arranged inside the recess between the hot and cold walls, the suspended element being capable of deforming between a position closer to the hot wall to a position closer to the cold wall or conversely under the action of the variation ΔT₁ in the temperature of one of these walls,
- the elastocaloric material is capable of transforming the mechanical stress variation that it undergoes when the suspended element deforms into a drop ΔT₂ in its internal temperature if the suspended element deforms from its closest position to the hot wall to its closest position to the cold wall under the action of the variation ΔT₁ or into a rise ΔT₂ in its internal temperature if the suspended element deforms from its closest position to the cold wall to its closest position to the hot wall under the action of the variation ΔT₁, and
- this device includes a transducer (34) capable of converting the deformation of the suspended element into electrical energy.

6. Device according to Claim 5, wherein the suspended element (24) comprises a first and a second layer (26, 28) of material directly fastened one on top of the other with no degree of freedom, each of these layers being made of a material having a different thermal expansion coefficient from the other layer so as to form a bimetallic strip capable of deforming under the action of the temperature variation ΔT₁.

7. Device according to Claim 6, wherein one of the first and of the second layers (26, 28) is made of an elastocaloric material to form the elastocaloric material layer and the other of the first and of the second layers (26, 28) is made of material incapable of generating a temperature variation greater than 0.5°C in response to the mechanical stress variation Δσ applied to this layer.

8. Device according to any one of Claims 1 to 4, wherein the device includes an actuator (96) capable of making the suspended element (82) oscillate between two states at a predetermined frequency for a given use temperature, and the elastocaloric material is capable of transforming the mechanical stress variation that it undergoes when the use temperature of the suspended element varies by ΔT₁ into a temperature variation ΔT₂ of opposite direction to the temperature variation ΔT₁.

9. Device according to Claim 8, wherein the elastocaloric material is capable of transforming the mechanical stress variation that it undergoes, when the use temperature of the suspended element (82) varies by ΔT₁, into a variation ΔT₂ of its internal temperature, the amplitude of which is equal to the amplitude of the variation ΔT₁ to within plus or minus 25 %.

10. Device according to Claim 8 or 9, wherein:
- the suspended element (82) is essentially made of a first material having a first thermal expansion coefficient and running between two ends,
- the device includes a rigid substrate (86) onto which the ends of the suspended element are fastened with no degree of freedom, this substrate being made of a second material having a second thermal expansion coefficient different from the coefficient of the first material so that the use temperature variation ΔT₁ causes the mechanical stress exerted on the suspended element to vary.

11. Device according to any one of Claims 8 to 10, wherein the elastocaloric material layer (104) is interposed between at least one of said ends of the suspended element (82) and the substrate (86).

12. Device according to any one of Claims 1 to 4, wherein the elastocaloric material layer (112) is capable of transforming the stress variation that it undergoes, when the temperature of the suspended element varies by ΔT₁, into a variation ΔT₂ of its internal temperature in the same direction as the first temperature variation ΔT₁.

13. Device according to any one of the preceding claims, wherein the elastocaloric material is chosen from the group composed of Cu_{68.13}Zn_{15.74}Al_{16.13}, the nickel and titanium alloys, the FeRh alloys, PZT, and the ferroelectric polymers.

14. Device according to any one of the preceding claims, wherein the suspended element (24; 82) runs essentially in a main direction and the elastocaloric material layer (30 ; 104 ; 112) covers at least 50 % of the suspended element in this main direction.

15. Method for generating a second temperature variation ΔT₂ from a first use temperature variation ΔT₁, this method comprising :
- the variation ΔT₁ (52) of the use temperature of a device including a suspended element, this suspended element being formed so as to make the mechanical stress applied to an elastocaloric material layer in mechanical contact with this suspended element vary by at least Δσ MPa in response to the use temperature variation ΔT₁, and
- in response, the variation by at least Δσ MPa of the mechanical stress applied by the suspended element to the elastocaloric material layer in mechanical contact with this suspended element, and
- the transformation (54) by the elastocaloric material layer of this mechanical stress variation into a variation ΔT₂ of its internal temperature that opposes, or conversely, increases the use temperature variation ΔT₁.

16. Method according to Claim 15, wherein the amplitude of the variation ΔT₁ is greater than 10°C and/or the amplitude of the variation ΔT₂ is greater than 10°C.
